# EUROPEAN PATENT SPECIFICATION

(11) **EP 3 055 884 B1**
(45) Date of publication and mention of the grant of the patent: **22.03.2023**
(21) Application number: 14870521.3
(22) Date of filing: 10.12.2014
(51) Int. Cl.: H01L 29/732, H01L 27/082, H01L 27/06, H01L 21/822, H01L 21/331, H01L 29/747, H01L 29/73, H01L 29/739

(54) **SYSTEMS AND METHODS FOR BIDIRECTIONAL DEVICE FABRICATION**
SYSTEME UND VERFAHREN ZUR HERSTELLUNG EINER BIDIREKTIONALEN VORRICHTUNG
SYSTÈMES ET PROCÉDÉS DE FABRICATION DE DISPOSITIFS BIDIRECTIONNELS

(30) Priority: 11.12.2013 US 201361914491 P; 08.01.2014 US 201461924884 P; 17.01.2014 US 201461928644 P; 21.01.2014 US 201461929874 P; 24.06.2014 US 201414313960
(43) Date of publication of application: 17.08.2016
(73) Proprietor: Ideal Power Inc., Austin, TX 78744 (US)
(72) Inventor: BLANCHARD, Richard A., Los Altos, California 94024 (US); ALEXANDER, William C., Spicewood, Texas 78669 (US)
(74) Representative: Pitchford, James Edward
(86) International application number: PCT/US2014/069611
(87) International publication number: WO 2015/089227

(56) References cited:
- EP-A1- 2 317 553
- WO-A2-2007/094824
- DE-A1-102004 005 384
- GB-A- 2 269 938
- US-A- 5 608 237
- US-A1- 2005 090 107
- US-A1- 2005 258 493
- US-A1- 2009 250 720
- US-A1- 2010 327 355
- US-A1- 2012 175 729
- US-A1- 2012 222 734
- US-A1- 2013 221 433

## Description

### BACKGROUND

The present application relates to semiconductor device fabrication, and more particularly to fabrication of two-sided and bidirectional semiconductor devices.

Note that the points discussed below may reflect the hindsight gained from the disclosed inventions, and are not necessarily admitted to be prior art.

Commonly-owned and co-pending application 14/313,960 taught novel bidirectional bipolar transistors known as B-TRANs. B-TRANs are three-layer four-terminal bidirectional bipolar transistors having at least two leads on each surface. One junction on each surface of the B-TRAN acts as an emitter or a collector, depending on the polarity of the applied voltage. Conventionally, fabrication of double-sided devices such as B-TRANs and bidirectional IGBTs is complicated and costly, since most conventional fabrication is not designed to allow for multiple electrodes on each wafer surface.

The majority of integrated circuits have all of their individual components fabricated on the front surface of the chip, though electrical contact may be made to the back surface of the chip. The majority of discrete devices having three or more terminals are configured similarly, with the top surface having two or more separate leads, while the entire back surface is another electrical lead. However, restricting one side of a device to only a single electrical lead necessarily precludes the fabrication of any devices having two or more leads on both surfaces.

Background art is provided in US 2009/250720 A1, WO 2007/094824 A2, GB 2 269 938 A, US 2012/222734 A1, DE 10 2004 005384 A1, and US 2013/221433 A1.

US 2009/250720 A1 discloses a transient voltage suppressor and method for manufacturing the same, the transient voltage suppressor having a dopant or carrier concentration in a portion of a gate region near a Zener region that is different from a dopant concentration in a portion of a gate region that is away from the Zener region.

WO 2007/094824 A2 discloses methods for fabricating thin film electronic devices with both front- and backside processing capabilities. Using such methods, it is disclosed that high temperature processing steps may be carried out during both frontside and backside processing.

GB 2 269 938 A discloses a semiconductor process for forming bipolar junction transistors and metal-oxide-semiconductor devices.

US 2012/222734 A1 discloses a solar battery cell and method for manufacturing the same.

DE 10 2004 005384 A1 discloses a bidirectional MOS-controlled semiconductor.

US 2013/221433 A1 discloses a vertical semiconductor device formed in a semiconductor layer having a first surface, a second surface and background doping. A first doped region, doped to a conductivity type opposite that of the background, is formed at the second surface of the semiconductor layer. A second doped region of the same conductivity type as the background is formed at the second surface of the semiconductor layer, inside the first doped region. A portion of the semiconductor layer is removed at the first surface, exposing a new third surface. A third doped region is formed inside the semiconductor layer at the third surface. Electrical contact is made at least to the second doped region (via the second surface) and the third doped region (via the new third surface).

### SYSTEMS AND METHODS FOR BIDIRECTIONAL DEVICE FABRICATION

The present invention is a method as defined in Claim 1 of the appended claims, of fabricating a semiconductor device.

The present application teaches, among other innovations, methods for fabricating double-sided semiconductor devices, in which multiple leads can be formed on each surface of a device.

The present application also teaches, among other innovations, systems for fabricating double-sided semiconductor devices, in which multiple leads can be formed on each surface of a device.

The present application also teaches, among other innovations, methods for operating systems to fabricate double-sided semiconductor devices, in which multiple leads can be formed on each surface of a device.

The above innovations are implemented, in various disclosed embodiments, by fabrication sequences using at least two handle wafers, comprising a single long dopant diffusion step that can be used to drive-in dopants on both sides of a device. High-temperature-resistant and medium-temperature-resistant handle wafers facilitate fabrication.

### BRIEF DESCRIPTION OF THE DRAWINGS

The disclosed inventions will be described with reference to the accompanying drawings, which show important sample embodiments and which are incorporated in the specification hereof by reference, wherein:
**Figure 1** schematically shows one sample embodiment of a process flow according to the present inventions.
**Figure 2A** shows one sample embodiment of a B-TRAN fabricated according to the present inventions.
**Figure 2B** shows one sample embodiment of a bidirectional p-channel IGBT fabricated according to the present inventions.
**Figures 3A****,** **3B****,** **3C****,** **3D****,** **3E****,** **3F****,** **3G****,** **3H****,** **3I****,** **3J****, and** **3K** show one sample embodiment of a fabrication process according to the present inventions.
**Figures 4A****,** **4B****,** **4C****,** **4D****,** **4E****,** **4F****,** **4G****,** **4H****,** **4I****,** **4J****,** **4K****, and** **4L** show another sample embodiment of a fabrication process according to the present inventions.
**Figures 5A****,** **5B****,** **5C****, and** **5D** show another sample embodiment of a partial fabrication process according to the present inventions.

### DETAILED DESCRIPTION OF SAMPLE EMBODIMENTS

The numerous innovative teachings of the present application will be described with particular reference to presently preferred embodiments (by way of example, and not of limitation). The present application describes several inventions, and none of the statements below should be taken as limiting the claims generally.

The present application discloses new approaches to two-sided device fabrication.

The innovative techniques of the present inventions teach, *inter alia,* innovative methods for fabrication of two-sided semiconductor devices, and particularly advantageously of vertically-symmetric two-sided semiconductor devices.

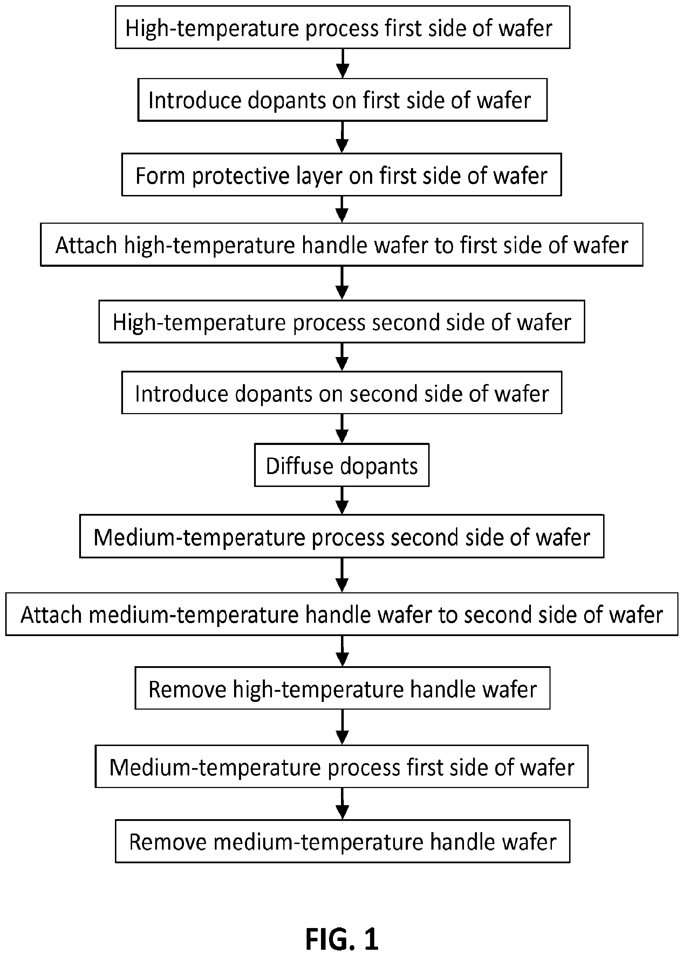

In most presently-preferred sample embodiments (such as the sample embodiment of **Figure 1**), most high-temperature processing steps are performed first on one side, up to but not including a dopant diffusion step. All dopants for the first side are preferably introduced among the last of the high-temperature processing steps, to minimize unwanted over- or under-diffusion of dopants from subsequent high-temperature steps. A protective stopping layer is deposited on the first side to protect against inadvertent or unwanted changes to the first side during subsequent processing.

A high-temperature handle wafer is then attached to the stopping layer, which aids in the later removal of the high-temperature handle wafer. The high-temperature handle wafer, stopping layer, and method of bonding these two are all chosen to be substantially unaffected by the high temperatures used in the later dopant drive-in step.

In some presently-preferred sample embodiments, the device wafer can then optionally be thinned from the second side, e.g. by grinding and polishing, to achieve the final desired device thickness before processing begins on the second side.

High-temperature processing steps are then preferably performed on the second side, with dopant introduction again preferably being among the last of these steps. After all dopants have been introduced, a single relatively-long dopant drive-in step can simultaneously diffuse all dopants on both sides to the desired depths, advantageously providing substantially symmetric dopant diffusion between both sides where desired.

Medium-temperature processing steps can then be performed on the exposed second side, after which a medium-temperature handle wafer can be attached to the second side. The high-temperature handle wafer is removed, and medium-temperature processing steps can be performed on the now-exposed first side. The medium-temperature handle wafer can then be removed. Conventional wafer processing is substantially concluded at this point. Low-temperature processing can proceed, including plating one or both sides of the wafer, dicing, and testing the resultant chips.

In some presently-preferred sample embodiments, high temperatures are above alloying temperatures for the metal or metals used in a given embodiment.

When an aluminum-based metallization system is used, the maximum temperature that conventional silicon wafers can experience without suffering irreversible damage is in the range of approximately 450-500°C. Above this temperature range, the aluminum begins to interact with the silicon, causing leakage, short circuits, and other well-known failures. Metal deposition thus preferably marks the beginning of medium-temperature processing, where medium temperatures can be defined as temperatures below those which can damage the wafer.

In most presently-preferred sample embodiments, medium temperatures also refer to temperatures in the approximate range of the alloying temperatures for the metal or metals used in a given embodiment.

In most presently-preferred sample embodiments, low temperatures are those below about the melting temperature of solder.

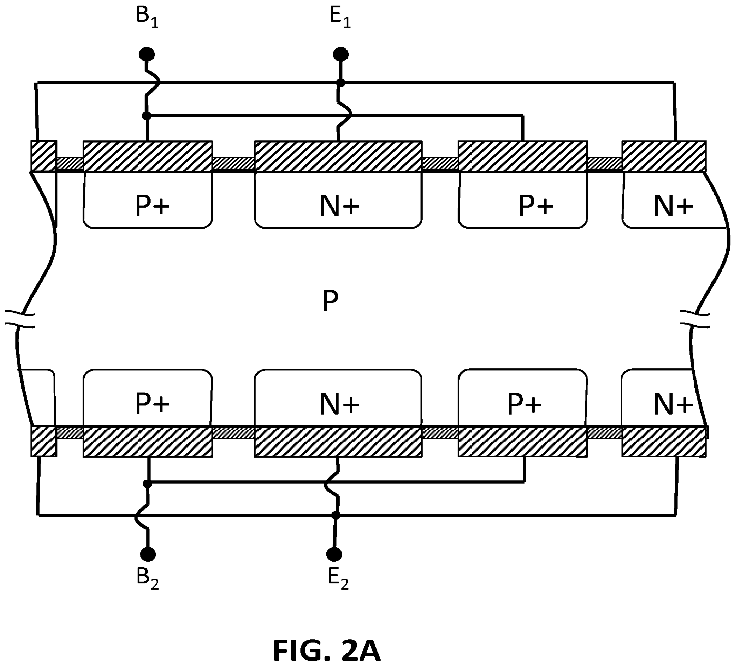

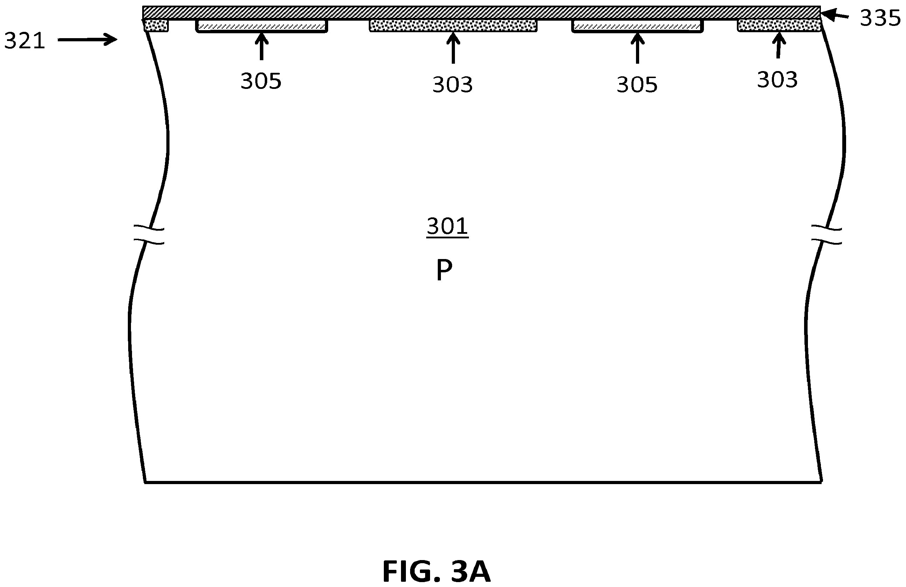

The sample process flow of **Figures 3A****-3L** shows one sample embodiment of the present inventions which can be used to fabricate a B-TRAN like that of **Figure 2A**.

In one sample embodiment, fabrication begins in **Figure 3A** with high-temperature processing of side **321** of p-type semiconductor wafer **301.** This high-temperature processing can, for example, include operations such as thermal oxidation, chemical vapor deposition (CVD), physical vapor deposition (PVD), high temperature anneals, and other processing occurring before dopant introduction. Any termination structures are most preferably formed at this stage of processing. N-type dopants **303** and p-type dopants **305** are most preferably introduced into wafer 301 among the last of these high-temperature steps. This phase of high-temperature processing of side 321 stops just before a high-temperature dopant diffusion step would conventionally be performed. Side 321 is overlain by silicon dioxide layer **335.**

In this sample embodiment, n-type dopants 303 eventually diffuse to form N+ regions, which act as emitter or collector regions for the B-TRAN, depending on the direction of current flow. P-type dopants 305 in other regions of side 321 form what will become P+ base contact regions.

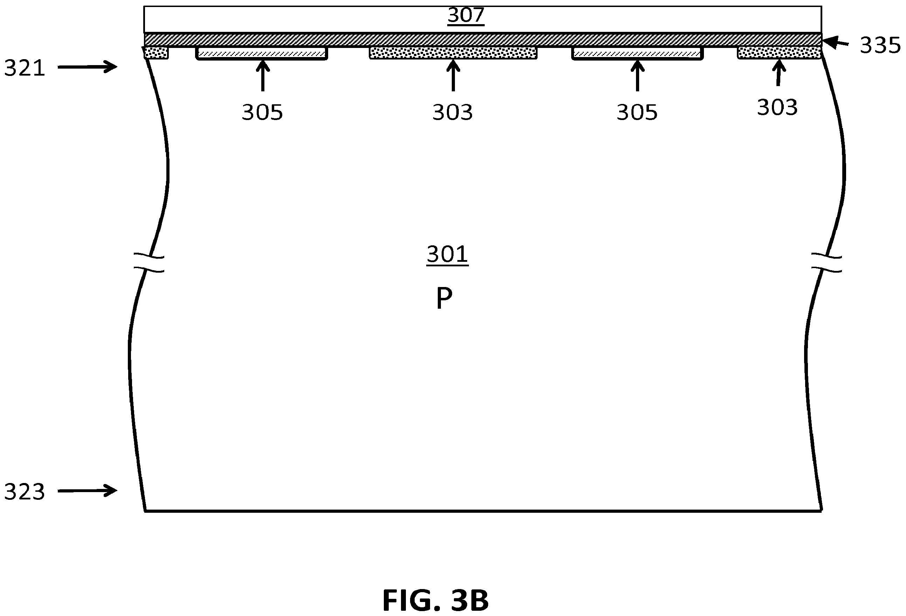

Protective layer **307** is then deposited on side 321 in **Figure 3B****.** Protective layer 307 helps minimize unwanted changes to side 321 during subsequent processing of opposite side **323** of wafer 301.

In one sample embodiment, protective layer 307 can be a single layer, e.g. of CVD silicon dioxide.

In another sample embodiment, protective layer 307 can be, for example, a sandwich of protective layers, e.g. two layers of CVD silicon dioxide separated by a layer of CVD silicon nitride.

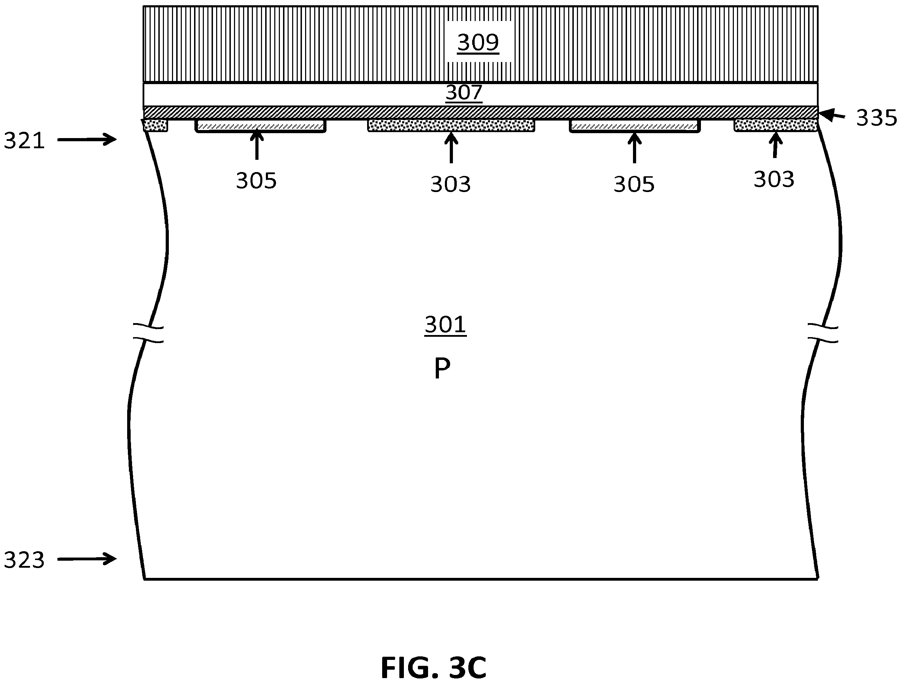

High-temperature handle wafer **309** is attached at high temperature to protective layer 307 on side 321, as seen in **Figure 3C****.** High-temperature handle wafer 309 is chosen to be substantially unaffected by the temperatures used in high-temperature fabrication on wafer 301, and particularly by temperatures used in the later dopant drive-in step. (For example, a mismatch in the coefficients of thermal expansion of silicon and quartz can warp the silicon wafer at bonding temperatures of about 400°C or above. Quartz is thus generally unacceptable as a high-temperature handle wafer, but can be used in some sample embodiments as a medium-temperature handle wafer.) The method of bonding high-temperature handle wafer 309 to protective layer 307 is also chosen to resist these high temperatures.

According to the invention, a silicon high-temperature handle wafer is bonded directly to a silicon dioxide protective layer by placing extremely flat wafer surfaces together at a medium temperature of 400°C to form a weak bond. The wafers are then placed in a furnace, for two hours at 100°C, to cause the silicon handle wafer to bond directly to the silicon dioxide protective layer.

In addition to preventing unwanted changes on side 321, protective layer 307 also provides a stopping point to avoid damaging the wafer, e.g. by over-thinning, when handle wafer 309 is later removed.

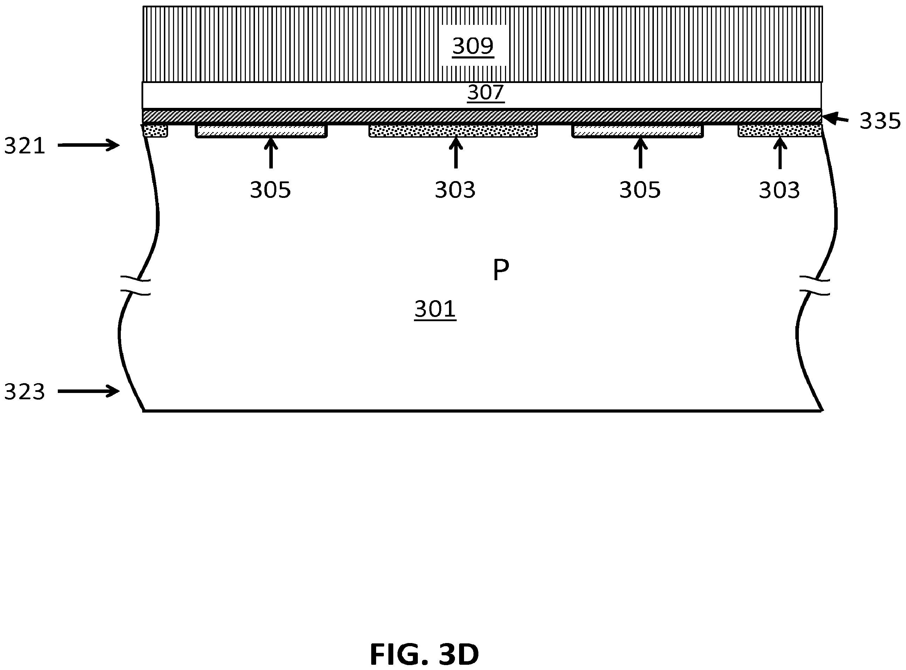

In the sample embodiment of Figures 3A-3K, the initial thickness of wafer 301 is larger than that desired for the final product. Wafer 301 is thus subsequently thinned from side 323 to the final thickness for the integrated circuit or discrete device, as in **Figure 3D****.** In one sample embodiment, this thinning can be performed by a combination of grinding, lapping, and polishing, in order to produce a device-quality surface.

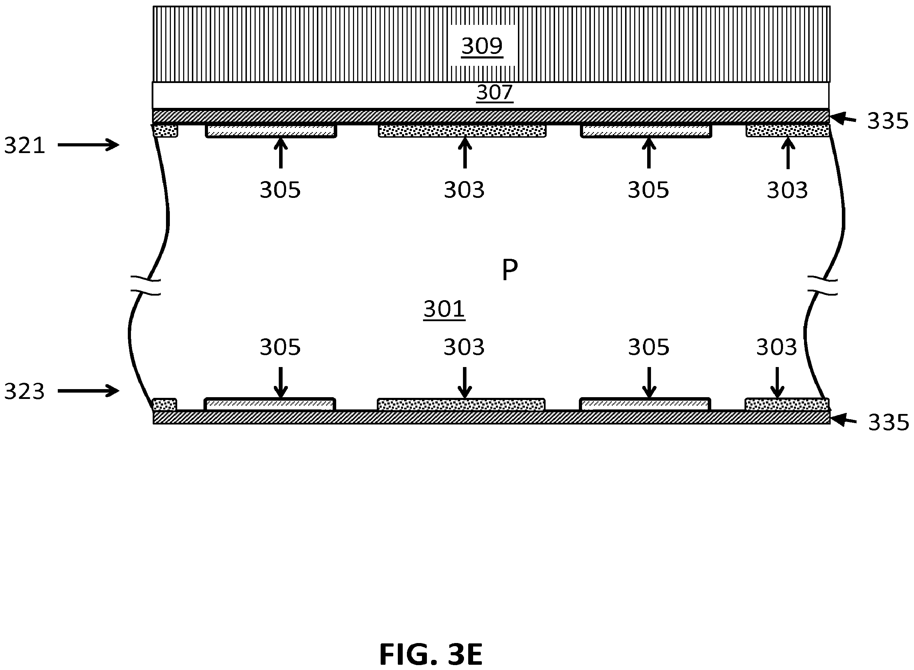

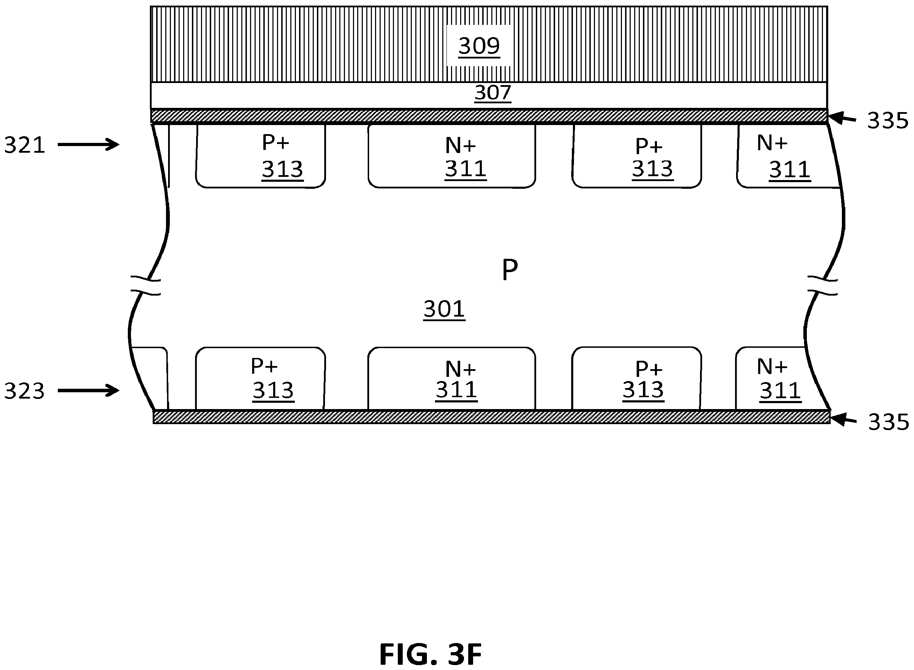

High-temperature processing is subsequently performed on side 323, up through the introduction of n-type dopants 303 and p-type dopants 305, as in **Figure 3E****.** This preferably mirrors on side 323 the high-temperature processing performed previously on side 321. A relatively long high-temperature diffusion step then diffuses dopants 303 and 305 on both sides of the wafer to desired junction depths. This dopant diffusion results in N+ emitter/collector regions **311** and P+ base contact regions **313** as seen in **Figure 3F****.**

In one sample embodiment, the desired junction depths are e.g. 3-5µm deep, and the diffusion step can be performed at a temperature of e.g. 1050-1100°C for e.g. 3-10 hours.

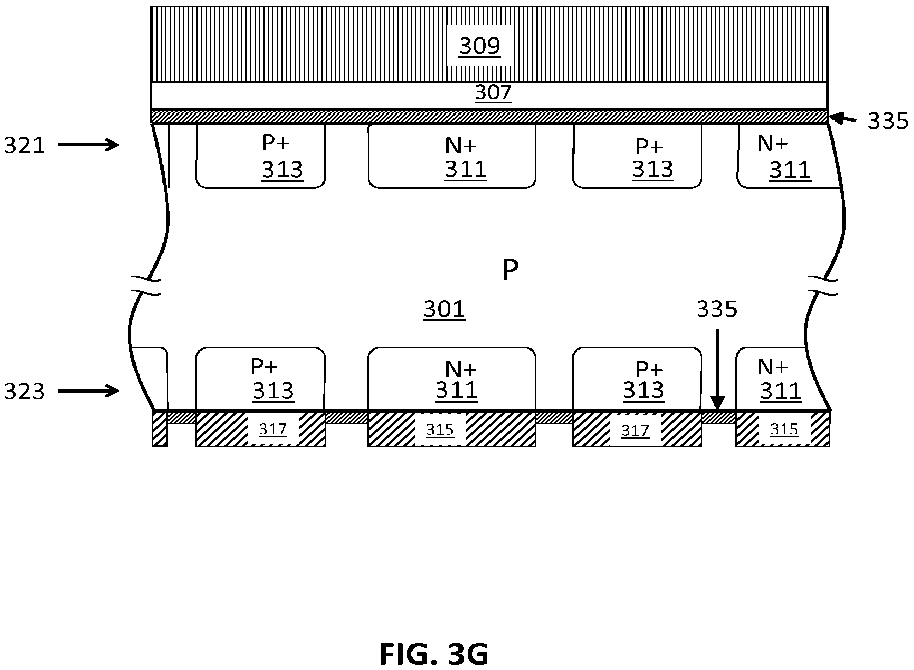

Medium-temperature processing is subsequently performed on side 323, as seen in **Figure 3G****.** This can include, for example, masked metal deposition and etching to form metal contact pads **315** and **317** over N+ regions 311 and P+ regions 313, respectively, on side 323. Metal contact pads 315 and 317 make contact to respective regions 311 and 313 through oxide layer 335. Medium-temperature processing can also include, for example, passivation of contact pads 315 and 317. As discussed above, typically no high-temperature processing occurs once metal pads 315 and 317 are present.

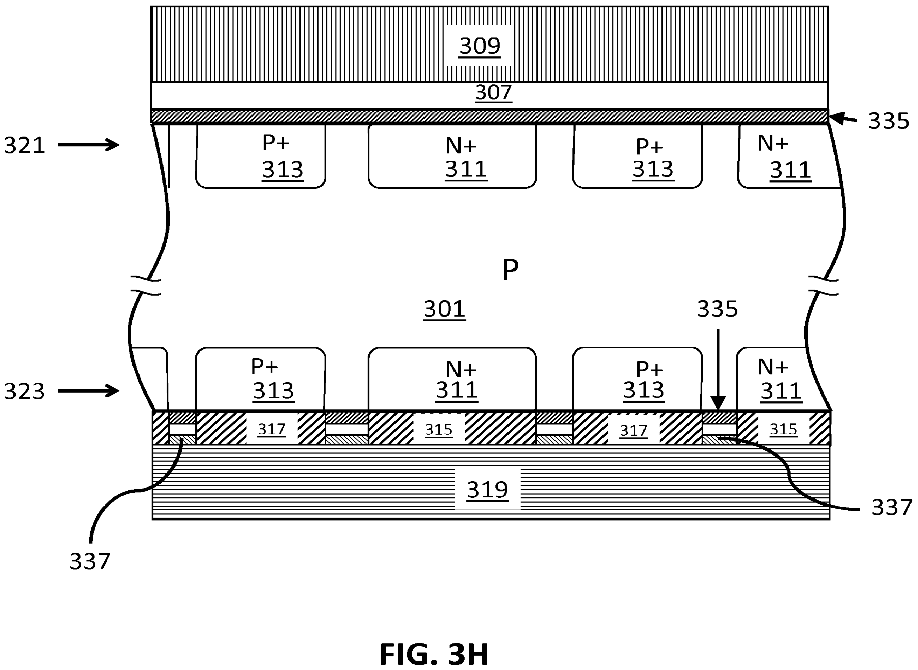

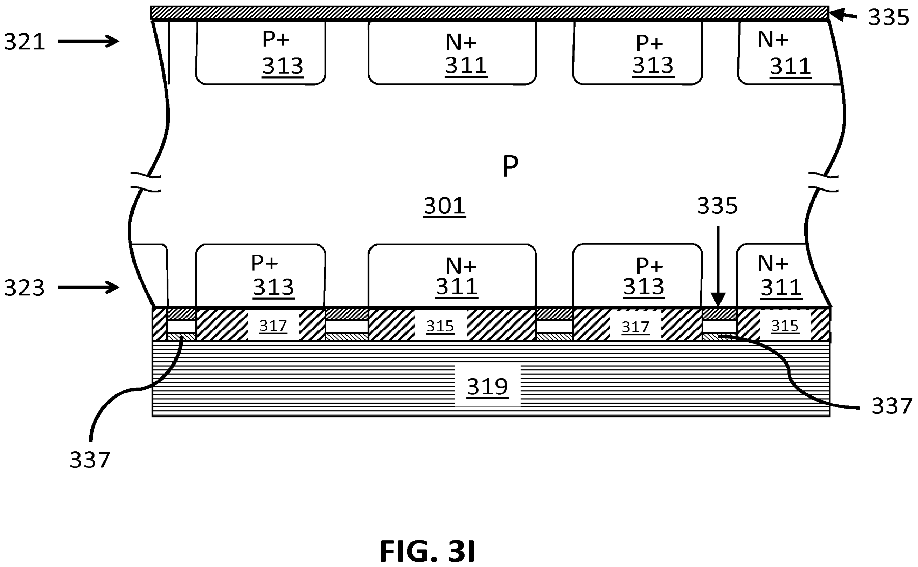

After medium-temperature processing of side 323 is completed, medium-temperature handle wafer **319** is attached to side 323 in **Figure 3H****.** In one sample embodiment, medium-temperature handle wafer 319 includes an adhesive layer to facilitate bonding to the device wafer. In one such sample embodiment, portions of this adhesive layer can partially or completely fill in gaps between the two wafers, as exemplified by adhesive portions **337.** High-temperature handle wafer 309 is then removed from side 321, preferably followed by most or all of protective layer 307, as in **Figure 3I**.

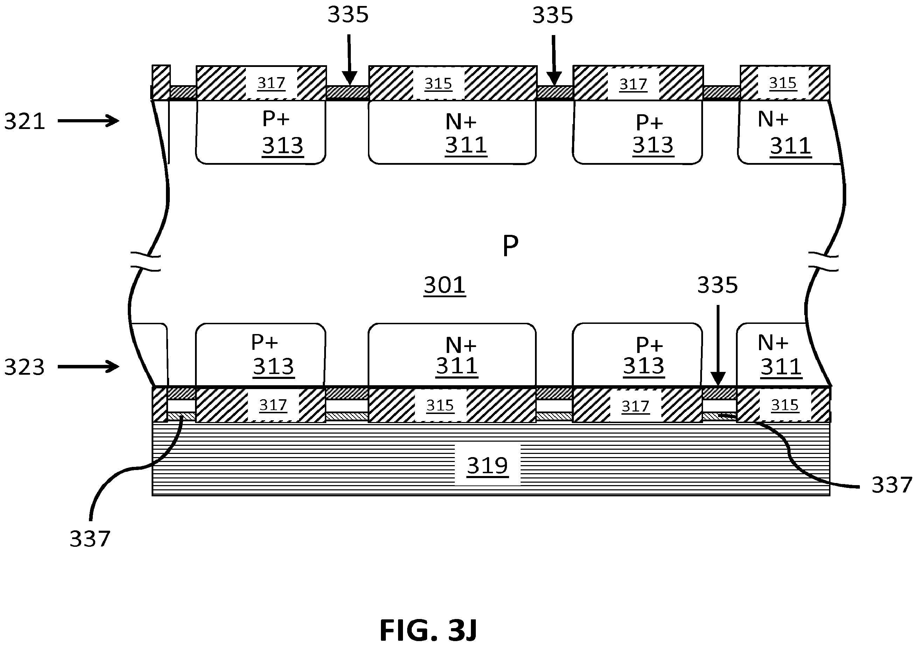

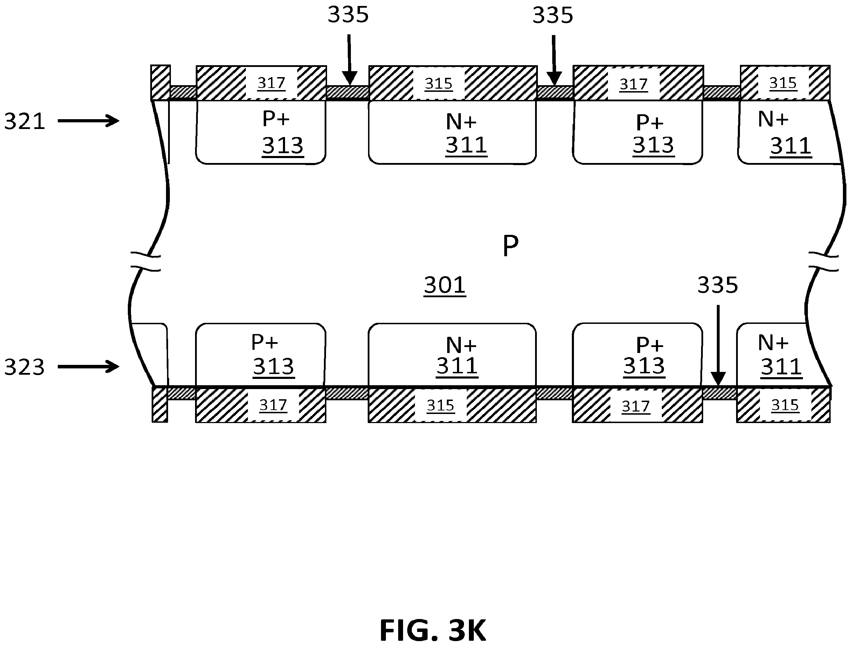

Medium-temperature processing is subsequently performed on side 321 in **Figure 3J****,** again forming metal contact pads 315 and 317 over N+ regions 311 and P+ regions 313, respectively, on side 321. Medium-temperature handle wafer 319 is removed in **Figure 3K****,** completing conventional wafer processing of wafer 301.

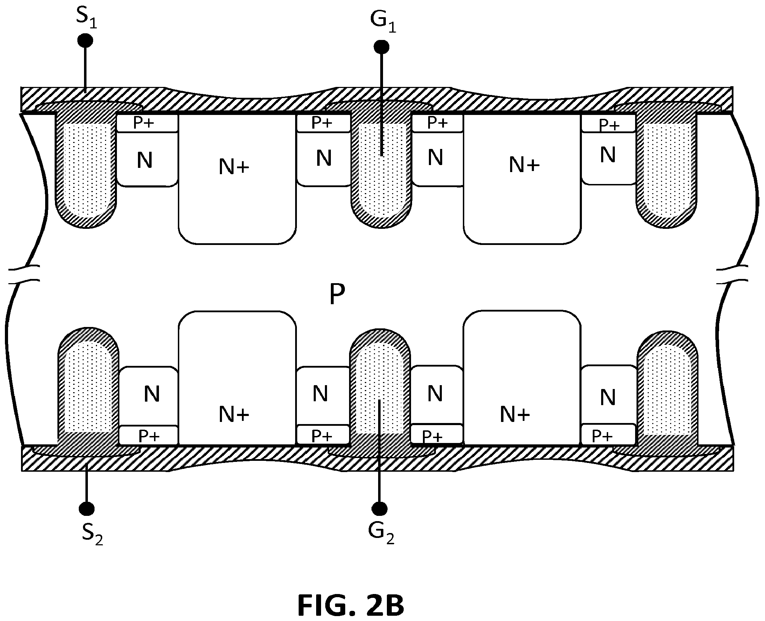

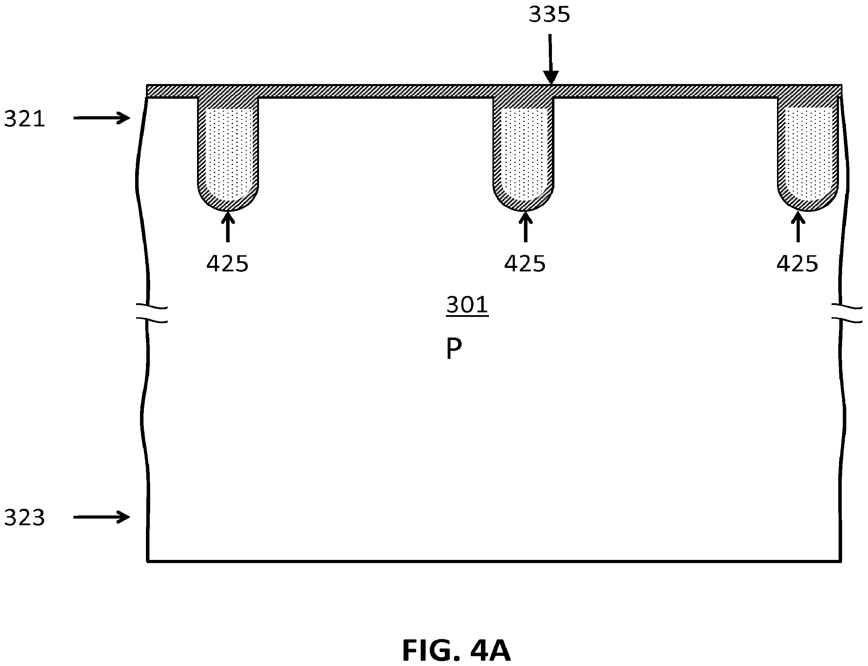

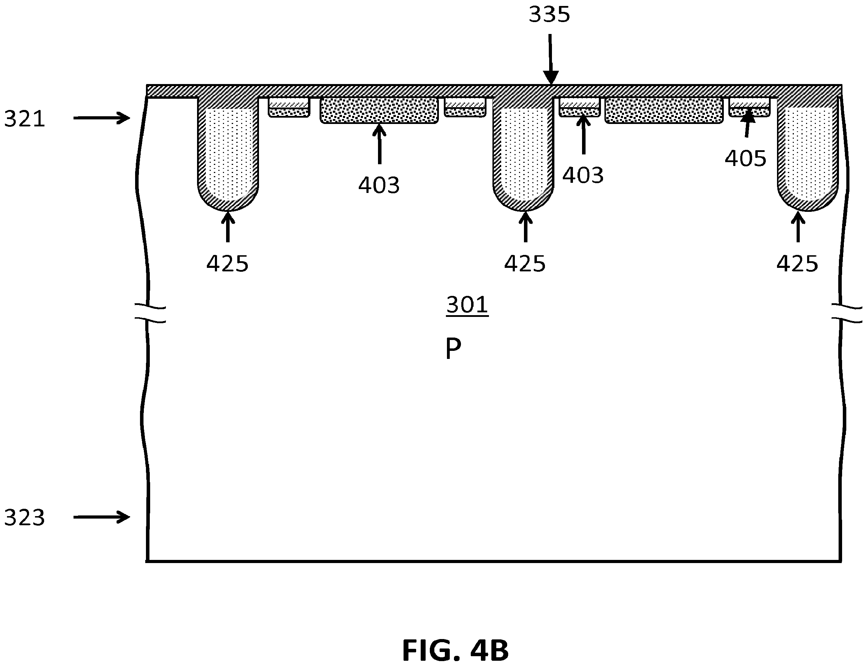

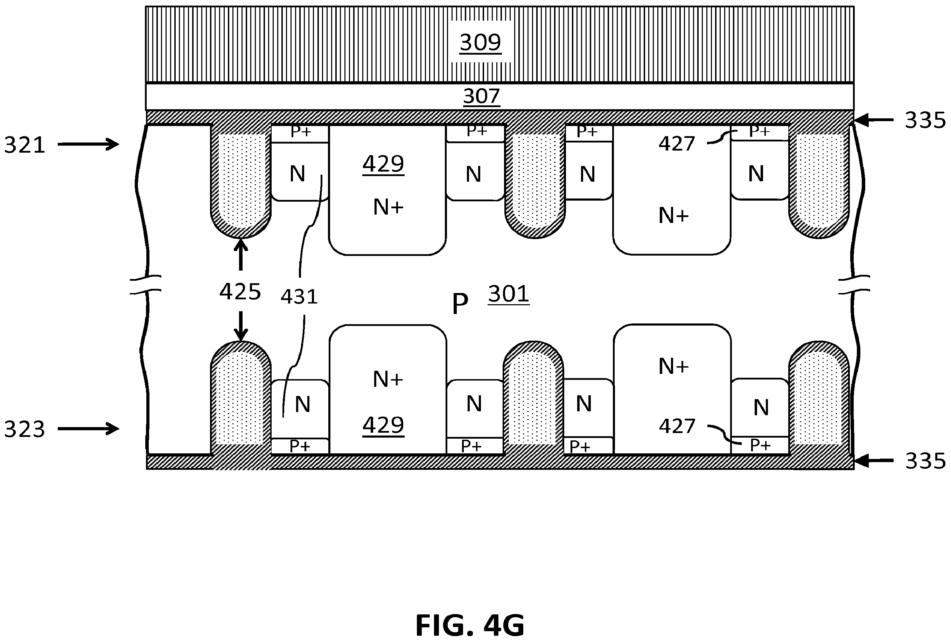

A similar exemplary process flow can be used in another sample embodiment to fabricate a bidirectional IGBT like that seen in **Figure 2B****.** In **Figure 4A****,** initial high-temperature processing of side 321 of wafer 301 includes forming trench gates **425,** as well as, for example, forming any termination structures and performing any other appropriate steps. Near the end of high-temperature processing of side 321, n-type dopants **403** and p-type dopants **405** are introduced in **Figure 4B****.**

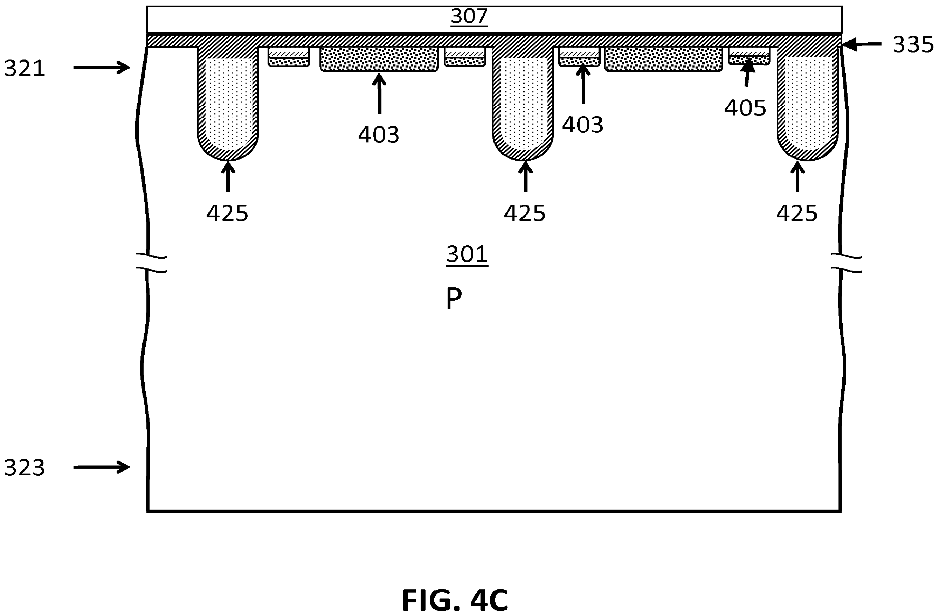

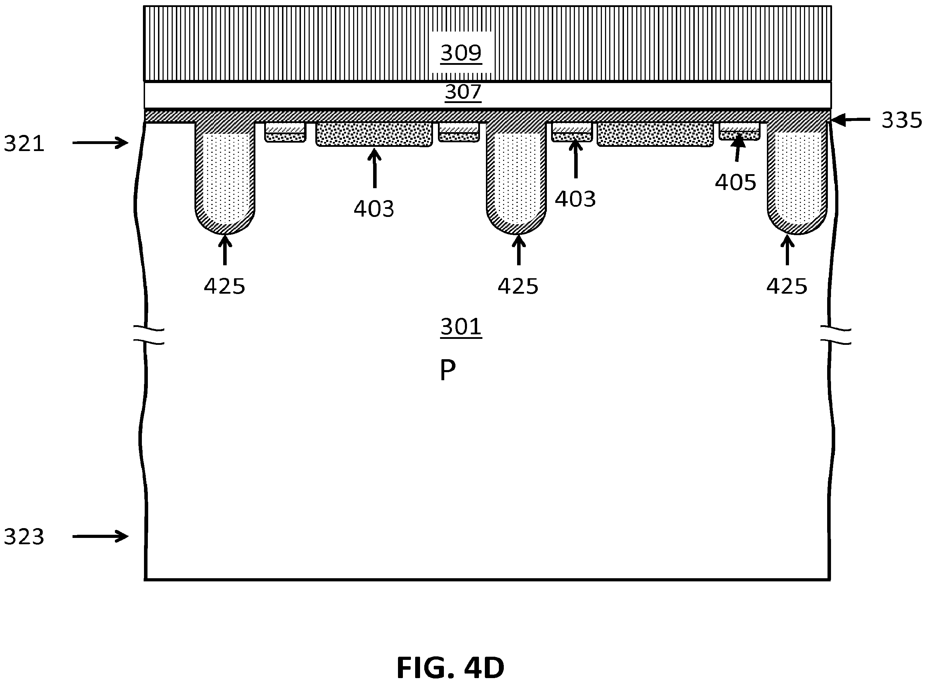

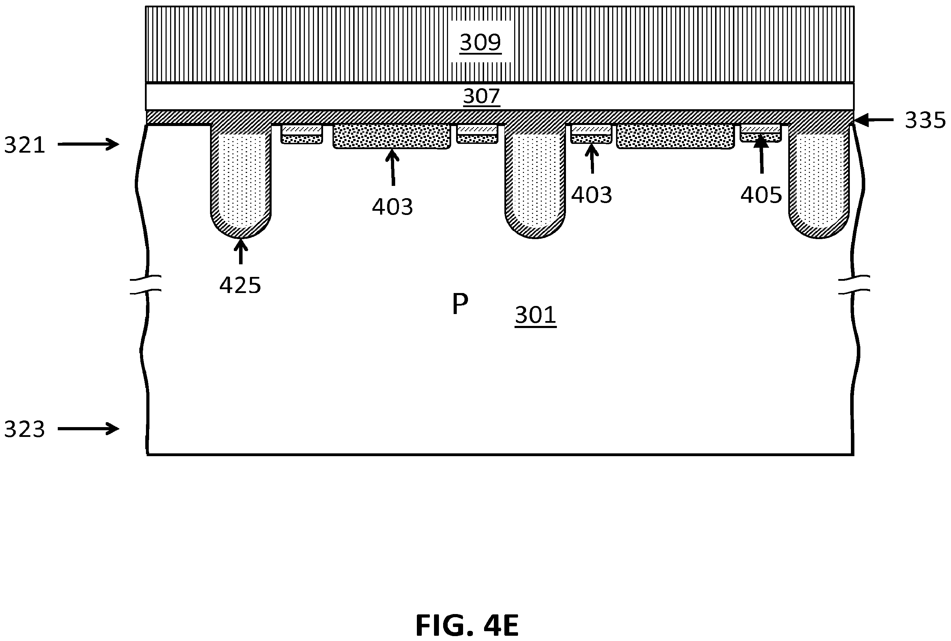

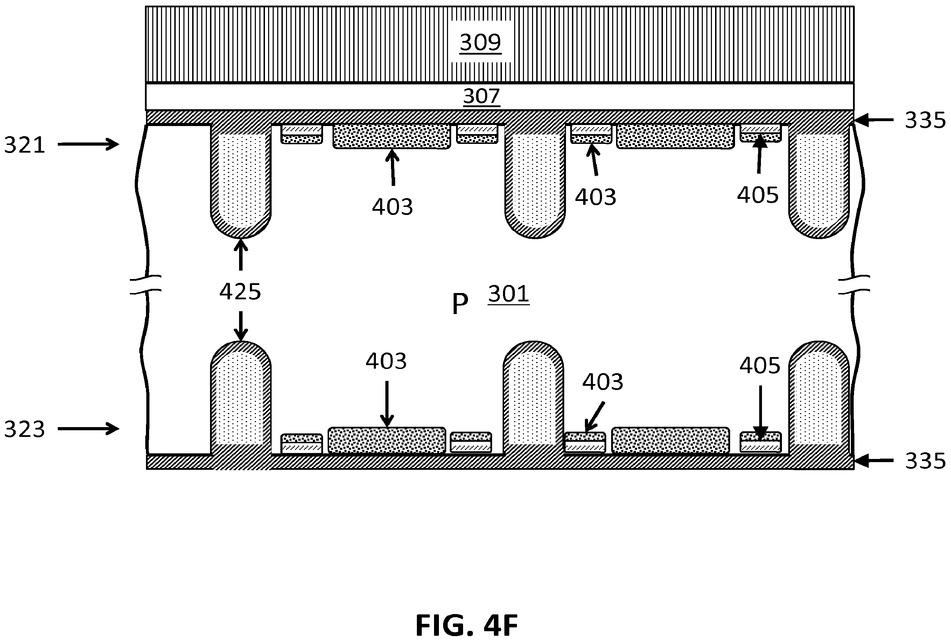

Protective layer 307 is formed on side 321 in **Figure 4C****,** over oxide layer 335. High-temperature handle wafer 309 is then attached to protective layer 307 in **Figure 4D****.** In one sample embodiment, the initial thickness of wafer 301 is greater than is desired for the final device, so wafer 301 is thinned from side 323 in **Figure 4E****.** High-temperature processing is performed on side 323 in **Figure 4F****,** including forming gate trenches 425 and oxide layer 335, and introducing n-type dopants 403 and p-type dopants 405. After a relatively long high-temperature diffusion step, dopants 403 and 405 on both sides 321 and 323 diffuse to form P+ source regions **427,** N+ body contact regions **429,** and N-type body regions **431.**

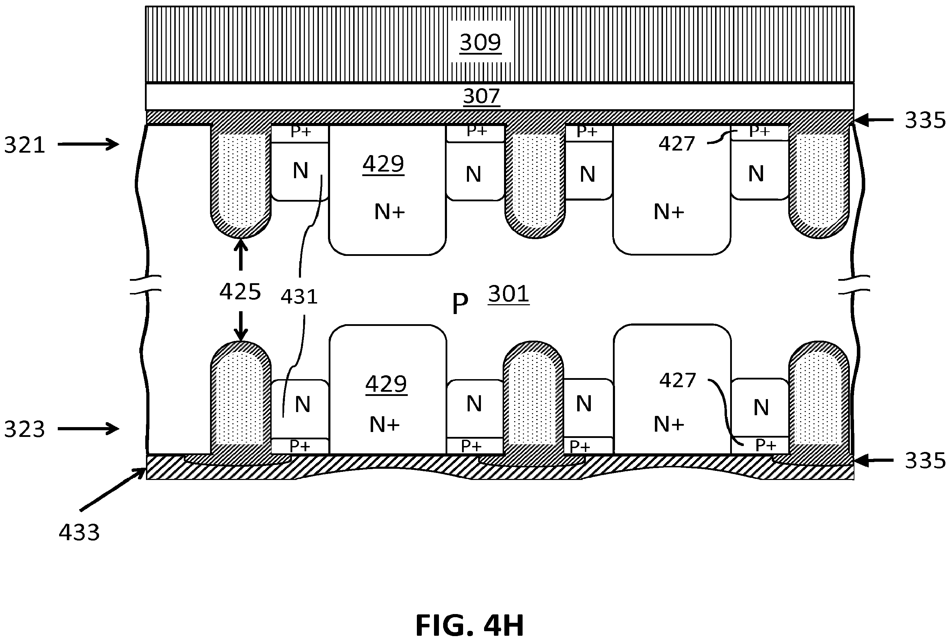

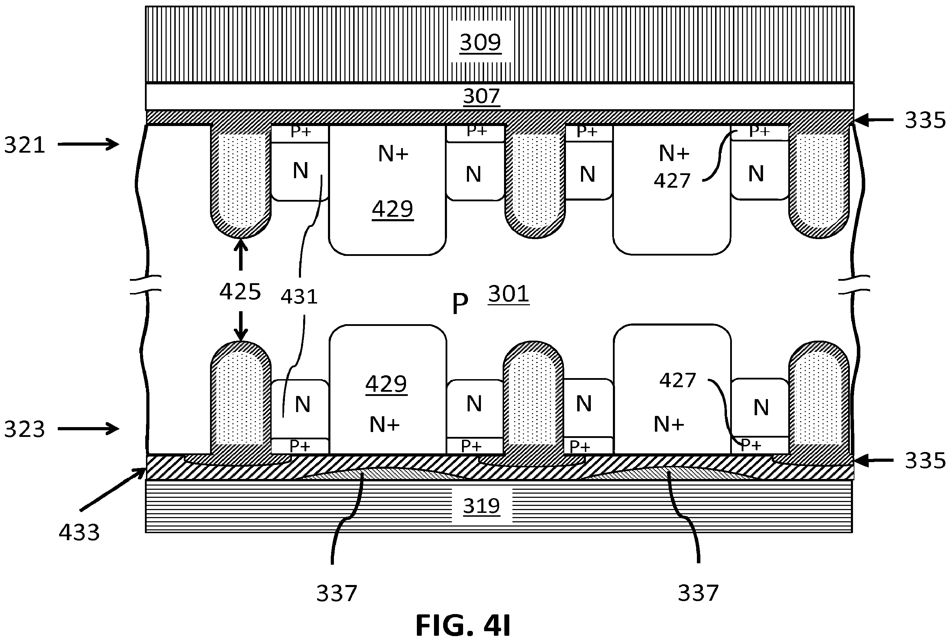

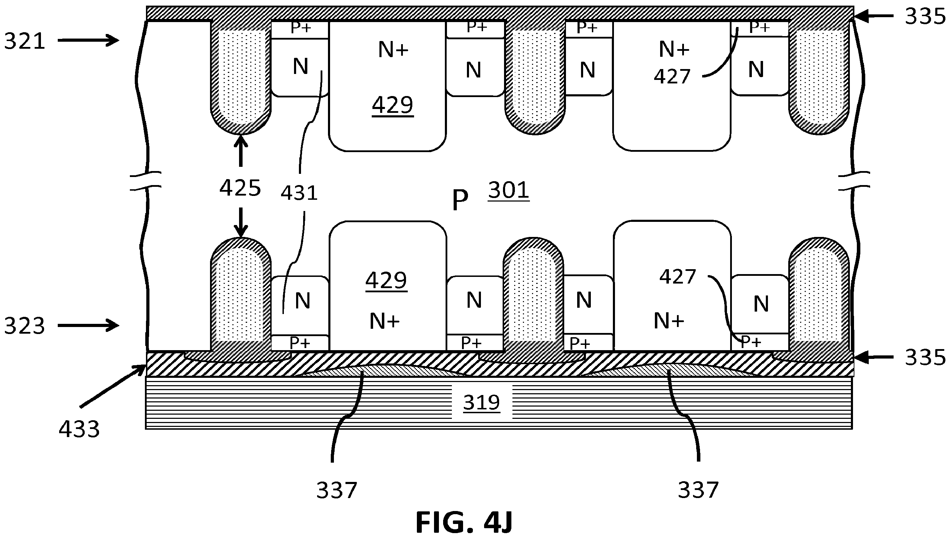

Medium-temperature processing on side 323 proceeds, including forming source contact metal **433** and contact pads in **Figure 4H****,** as well as making contact (not shown) to trench gates 425. After medium-temperature processing of side 323 is substantially completed, medium-temperature handle wafer 319 is attached to side 323 in **Figure 4I** to enable processing of side 321. In one sample embodiment, medium-temperature handle wafer 319 is attached to side 323 using a medium-temperature adhesive, portions of which can be seen in gaps as adhesive 337. High-temperature handle wafer 309 is removed from side 321, along with (in this sample embodiment) protective layer 307, freeing side 321 as seen in **Figure 4J****.**

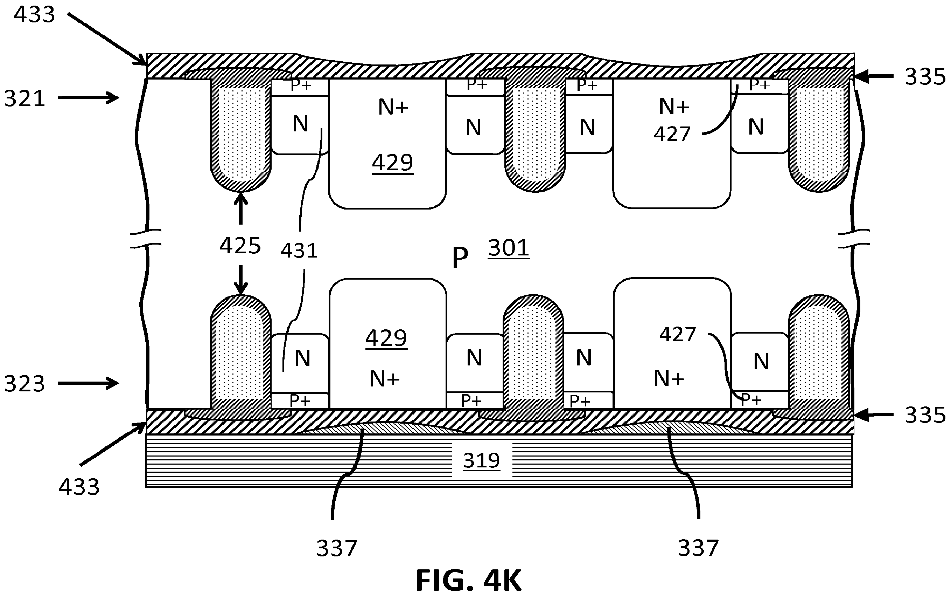

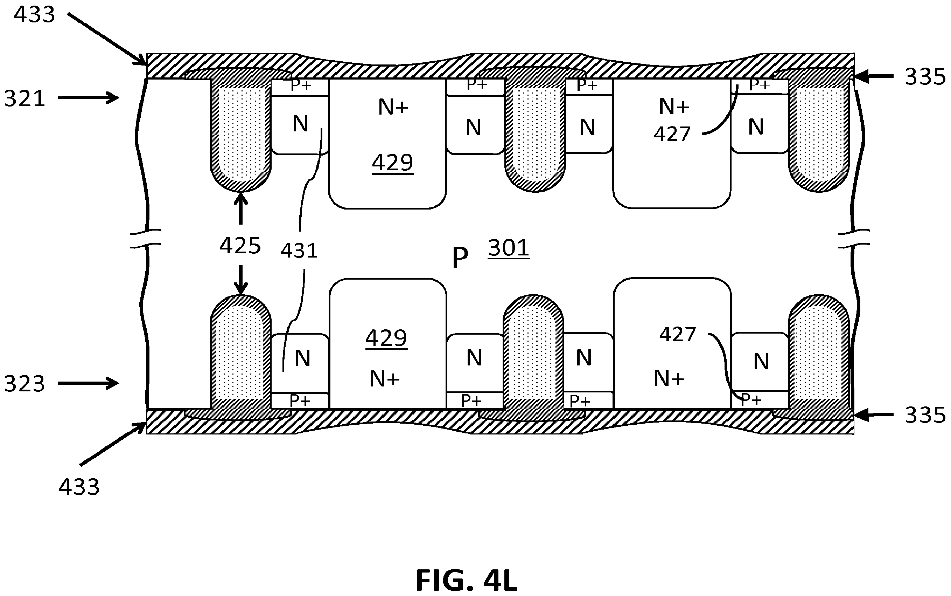

Medium-temperature processing of side 321 proceeds, including forming source contact metal 433 and contact pads on side 321 and making contact (not shown) to trench gates 425 in **Figure 4K****.** Conventional wafer processing of wafer 301 concludes in **Figure 4L** with the removal of medium-temperature handle wafer 319 (as well as any excess adhesive 337).

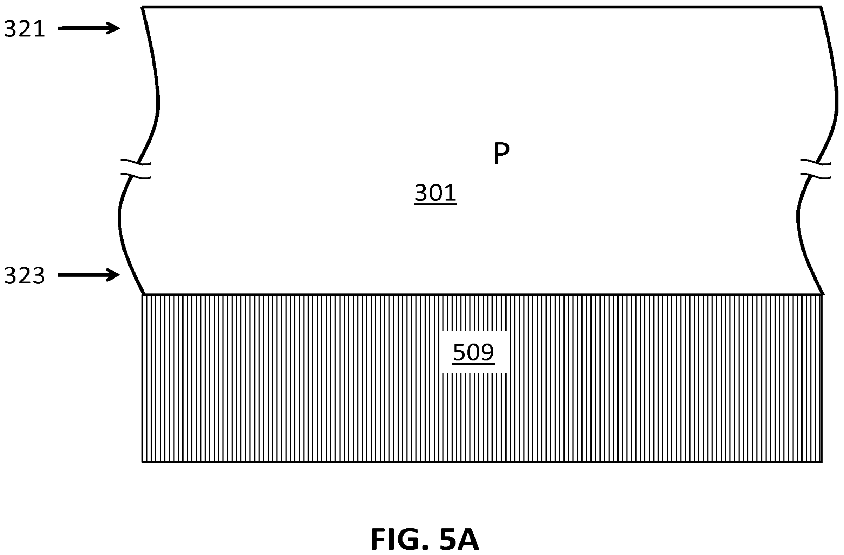

In some sample embodiments, the initial device wafer is so thin that it cannot undergo conventional processing steps. In sample embodiments like that of **Figures 5A-5D****,** three handle wafers in total are used instead of two: two handle wafers bonded at high temperature, and one handle wafer bonded at medium temperature. In **Figure 5A****,** side 323 of thin device wafer 301 is attached to high-temperature handle wafer **509** before processing begins on first side 321.

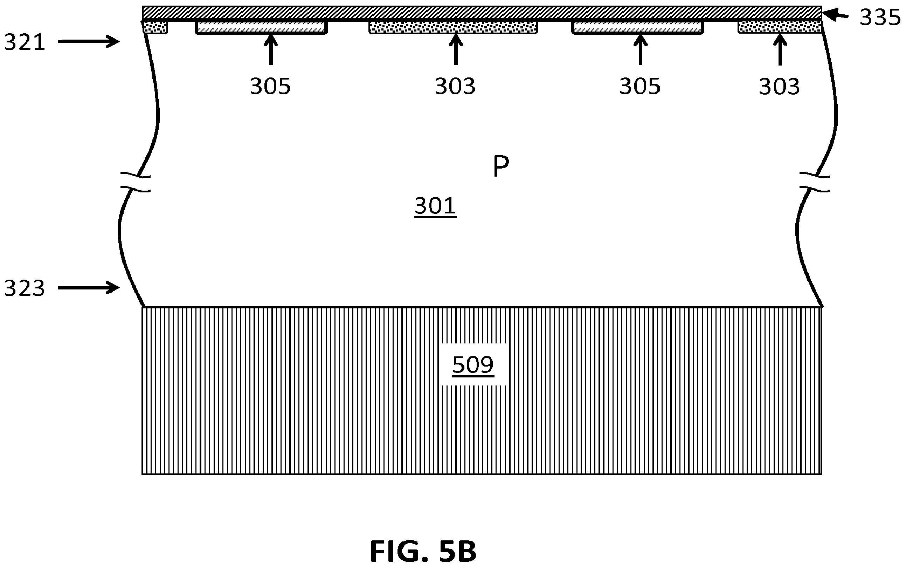

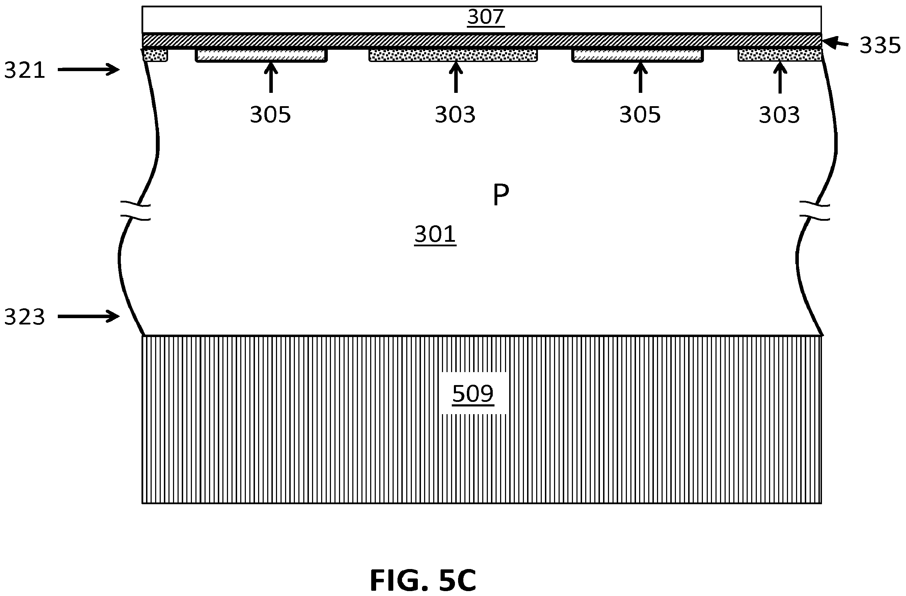

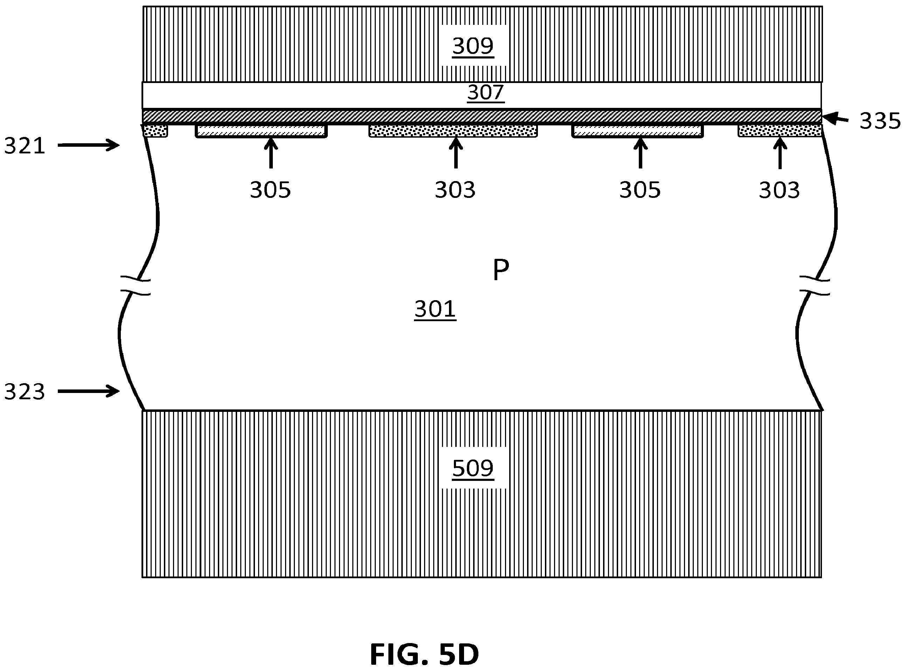

**Figures 5B****,** **5C****,** and **5D** respectively parallel the processing steps of Figures 3A, 3B, and 3C in the presence of handle wafer 509. Once wafer 301 is attached to high-temperature handle wafer 309, handle wafer 509 can be removed, and fabrication can proceed as seen in the sample embodiment of Figures 3D-3K.

### Advantages

The disclosed innovations, in various embodiments, provide one or more of at least the following advantages. However, not all of these advantages result from every one of the innovations disclosed, and this list of advantages does not limit the scope of the appended claims.
- Simplifies fabrication of two-sided devices;
- Diffuses dopants on both faces to acceptably similar depths;
- Permits efficient fabrication of multiple active regions and multiple electrodes on both sides of devices;
- Allows processing of extremely thin device wafers through conventional fabrication processes and systems, since after thinning the wafer is always attached to a handle wafer through the remainder of conventional wafer fabrication;
- Allows vertically-symmetric device fabrication without damage to the device.

### Modifications and Variations

As will be recognized by those skilled in the art, the innovative concepts described in the present application can be modified and varied over a tremendous range of applications, and accordingly the scope of patented subject matter is not limited by any of the specific exemplary teachings given. It is intended to embrace all such alternatives, modifications and variations that fall within the scope of the appended claims.

Additional general background, which helps to show variations and implementations, as well as some features which can be implemented synergistically with the subject-matter claimed below, may be found in the following US patent applications. All of these applications have at least some common ownership, copendency, and inventorship with the present application: US 8,406,265, US 8,400,800, US 8,395,910, US 8,391,033, US 8,345,452, US 8,300,426, US 8,295,069, US 7,778,045, US 7,599,196; US 2012-0279567 A1, US 2012-0268975 A1, US 2012-0274138 A1, US 2013-0038129 A1, US 2012-0051100 A1; PCT/US14/16740, PCT/US14/26822, PCT/US14/35954, PCT/US14/35960; 14/182,243, 14/182,236, 14/182,245, 14/182,246, 14/183,403, 14/182,249, 14/182,250, 14/182,251, 14/182,256, 14/182,268, 14/183,259, 14/182,265, 14/183,415, 14/182,280, 14/183,422, 14/182,252, 14/183,245, 14/183,274, 14/183,289, 14/183,309, 14/183,335, 14/183,371, 14/182,270, 14/182,277, 14/207,039, 14/209,885, 14/260,120, 14/265,300, 14/265,312, 14/265,315, 14/313,960, 14/479,857, 14/514,878, 14/514,988, 14/515,348; US Provisionals 61/914,491 and 61/914,538 filed December 11, 2013; 61/924,884 filed January 8, 2014; 61/925,311 filed January 9, 2014; 61/928,133 filed January 16, 2014; 61/928,644 filed January 17, 2014; 61/929,731 and 61/929,874 filed January 21, 2014; 61/931,785 filed January 27, 2014; 61/932,422 filed January 28, 2014; 61/933,442 filed January 30, 2014; 62/007,004 filed June 3, 2014; 62/008,275 filed June 5, 2014; 62/015,096 filed June 20, 2014; 62/052,358 filed September 18, 2014; 62/054,621 filed September 24, 2014; 62/055,167 filed September 25, 2014; 62/060,312 filed October 6, 2014; 62/063,090 filed October 13, 2014; 62/064,616 filed October 16, 2014; 62/065,916 filed October 20, 2014; 62/073,809 filed October 31, 2014; and all priority applications of any of the above thereof.

None of the description in the present application should be read as implying that any particular element, step, or function is an essential element which must be included in the claim scope: THE SCOPE OF PATENTED SUBJECT MATTER IS DEFINED ONLY BY THE ALLOWED CLAIMS.

## Claims

1. A method of fabricating a semiconductor device, comprising, in order, steps of
introducing first-conductivity-type dopants (303) into first regions on a first face (321) of a semiconductor wafer (301);
introducing second-conductivity-type dopants (305) into second regions on said first face (321);
forming a silicon dioxide protective layer (307) on said first face (321);
attaching a first handle wafer (309) to said protective layer (307) on said first face (321) by placing an extremely flat surface of said first handle wafer (309) and an extremely flat surface of said protective layer (307) together at a medium temperature of 400°C, to form a weak bond, and then placing the wafers in a furnace for two hours at 1100°C, to cause said first handle wafer (309) to bond directly to said protective layer (307), said first handle wafer (309) being formed of silicon;
introducing first-conductivity-type dopants (303) into third regions on a second face (323) of said semiconductor wafer (301) which is parallel to said first face (321);
introducing second-conductivity-type dopants (305) into fourth regions on said second face (323);
performing a high-temperature diffusion step at a temperature above 600°C, whereby said diffusion step diffuses the first-conductivity-type dopants (303) and the second-conductivity-type dopants (305) to desired depths, from both said first and second faces (321, 323), into said semiconductor wafer (301);
performing medium-temperature fabrication steps on said second face (323);
attaching, using an adhesive layer (337), a second handle wafer (319) to said second face (323);
removing said first handle wafer (309); and
performing medium-temperature fabrication steps on said first face (321).

2. The method of Claim 1, wherein both p-type and n-type dopants are introduced, in respective patterns and not overall, on both said first and second faces (321, 323) of said semiconductor wafer (301).

3. The method of Claim 1, wherein the diffusion step uses a higher sustained temperature than any step thereafter.

4. The method of Claim 1, wherein the steps of introducing dopants (303, 305) into said first and second regions on said first face (321) use the same patterns as the steps of introducing dopants (303, 305) into said third and fourth regions on said second face (323), respectively.

5. The method of Claim 1, wherein the connection between each said handle wafer (309, 319) and said semiconductor wafer (301) is unaffected by temperatures used after the respective attaching step.

6. The method of Claim 1, wherein said medium-temperature fabrication steps are performed at temperatures below 450°C,

7. The method of Claim 1, further comprising:
performing high-temperature fabrication steps on said first face (321) of said semiconductor wafer (301), prior to the step of introducing first-conductivity-type dopants (303) into said first regions on said first face (321);
performing high-temperature fabrication steps on said second face (323) of said semiconductor wafer (301), prior to the step of introducing first-conductivity-type dopants (303) into said third regions on said second face (323);
removing said second handle wafer (319) from said second face (323), after the step of performing medium-temperature fabrication steps on said first face (321); and
performing low-temperature processing steps on said semiconductor wafer (301) at temperatures below 240°C;
wherein the medium-temperature fabrication steps are performed at temperatures below 450°C; and
wherein at least some said high-temperature fabrication steps are performed at temperatures above 600°C.

8. The method of Claim 7, further comprising forming trench gates (425) on the respective face before introducing the dopants (303, 305) into each said face (321, 323).

9. The method of Claim 7, wherein said diffusion step is performed at temperatures above 1000°C.

10. The method of Claim 1, further comprising, after the step of attaching the first handle wafer (309) to said first face (321), and before the step of introducing first-conductivity-type dopants (303) into said third regions on said second face (323), a step of
thinning said semiconductor wafer (301), from said second face (323), to a desired thickness.

## Patentansprüche

1. Verfahren zur Herstellung eines Halbleiterbauelements, das der Reihe nach die folgenden Schritte beinhaltet:
Einbringen von Dotierstoffen (303) des ersten Leitfähigkeitstyps in erste Regionen auf einer ersten Fläche (321) eines Halbleiterwafers (301);
Einbringen von Dotierstoffen (305) des zweiten Leitfähigkeitstyps in zweite Regionen auf der genannten ersten Fläche (321);
Bilden einer Siliciumdioxid-Schutzschicht (307) auf der genannten ersten Fläche (321);
Anbringen eines ersten Handhabungswafers (309) an der genannten Schutzschicht (307) auf der genannten ersten Fläche (321) durch gemeinsames Platzieren einer extrem flachen Fläche des genannten ersten Handhabungswafers (309) und einer extrem flachen Fläche der genannten Schutzschicht (307) bei einer mittleren Temperatur von 400°C, um eine schwache Bindung zu bilden, und dann Platzieren der Wafer zwei Stunden lang in einem Ofen bei 1100°C, um zu bewirken, dass der genannte erste Handhabungswafer (309) direkt mit der genannten Schutzschicht (307) verbunden wird, wobei der genannte erste Handhabungswafer (309) aus Silicium gebildet ist;
Einbringen von Dotierstoffen (303) des ersten Leitfähigkeitstyps in dritte Regionen auf einer zweiten Fläche (323) des gennanten Halbleiterwafers (301), die parallel zu der genannten ersten Fläche (321) ist;
Einbringen von Dotierstoffen (305) des zweiten Leitfähigkeitstyps in vierte Regionen auf der genannten zweiten Fläche (323);
Durchführen eines Hochtemperaturdiffusionsschritts bei einer Temperatur über 600°C, so dass der genannte Diffusionsschritt die Dotierstoffe (303) des ersten Leitfähigkeitstyps und die Dotierstoffe (305) des zweiten Leitfähigkeitstyps bis zu gewünschten Tiefen sowohl von der genannten ersten als auch von der genannten zweiten Fläche (321, 323) in den genannten Halbleiterwafer (301) diffundiert;
Durchführen von Mitteltemperaturherstellungsschritten an der genannten zweiten Fläche (323);
Anbringen eines zweiten Handhabungswafers (319) mittels einer Klebstoffschicht (337) an der genannten zweiten Fläche (323);
Entfernen des genannten ersten Handhabungswafers (309); und
Durchführen von Mitteltemperaturherstellungsschritten an der genannten ersten Fläche (321).

2. Verfahren nach Anspruch 1, wobei sowohl p-Typals auch n-Typ-Dotierstoffe in jeweiligen Mustern und nicht insgesamt sowohl auf der genannten ersten als auch auf der genannten zweiten Fläche (321, 323) des genannten Halbleiterwafers (301) eingebracht werden.

3. Verfahren nach Anspruch 1, wobei der Diffusionsschritt eine höhere Dauertemperatur verwendet als irgendein Schritt danach.

4. Verfahren nach Anspruch 1, wobei die Schritte des Einbringens von Dotierstoffen (303, 305) in die genannte erste und zweite Region auf der genannten ersten Fläche (321) die gleichen Muster verwenden wie die Schritte des Einbringens von Dotierstoffen (303, 305) in die genannte dritte bzw. vierte Region auf der genannten zweiten Fläche (323) .

5. Verfahren nach Anspruch 1, wobei die Verbindung zwischen jedem genannten Handhabungswafer (309, 319) und dem genannten Halbleiterwafer (301) durch die nach dem jeweiligen Anbringungsschritt verwendeten Temperaturen nicht beeinträchtigt wird.

6. Verfahren nach Anspruch 1, wobei die genannten Mitteltemperaturherstellungsschritte bei Temperaturen unter 450°C durchgeführt werden.

7. Verfahren nach Anspruch 1, das ferner Folgendes beinhaltet:
Durchführen von Hochtemperaturherstellungsschritten auf der genannten ersten Fläche (321) des genannten Halbleiterwafers (301) vor dem Schritt des Einbringens von Dotierstoffen (303) des ersten Leitfähigkeitstyps in die genannten ersten Regionen auf der genannten ersten Fläche (321) ;
Durchführen von Hochtemperaturherstellungsschritten auf der genannten zweiten Fläche (323) des genannten Halbleiterwafers (301) vor dem Schritt des Einbringens von Dotierstoffen (303) des ersten Leitfähigkeitstyps in die genannten dritten Regionen auf der gennanten zweiten Fläche (323) ;
Entfernen des genannten zweiten Handhabungswafers (319) von der genannten zweiten Fläche (323) nach dem Schritt des Durchführens von Mitteltemperaturherstellungsschritten auf der genannten ersten Fläche (321); und
Durchführen von Niedertemperaturverarbeitungsschritten an dem genannten Halbleiterwafer (301) bei Temperaturen unter 240°C;
wobei die Mitteltemperaturherstellungsschritte bei Temperaturen unter 450°C durchgeführt werden; und
wobei zumindest einige der Hochtemperaturherstellungsschritte bei Temperaturen über 600°C durchgeführt werden.

8. Verfahren nach Anspruch 7, das ferner das Ausbilden von Grabengates (425) auf der jeweiligen Fläche vor dem Einbringen der Dotierstoffe (303, 305) in jede der genannten Flächen (321, 323) beinhaltet.

9. Verfahren nach Anspruch 7, wobei der genannte Diffusionsschritt bei Temperaturen über 1000°C durchgeführt wird.

10. Verfahren nach Anspruch 1, das ferner nach dem Schritt des Anbringens des ersten Handhabungswafers (309) an der genannten ersten Fläche (321) und vor dem Schritt des Einbringens von Dotierstoffen (303) des ersten Leitfähigkeitstyps in die genannten dritten Regionen auf der genannten zweiten Fläche (323) den folgenden Schritt beinhaltet:
Ausdünnen des genannten Halbleiterwafers (301) von der genannten zweiten Fläche (323) auf eine gewünschte Dicke.

## Revendications

1. Procédé de fabrication d'un dispositif semi-conducteur, comprenant, dans l'ordre, des étapes :
d'introduction de dopants d'un premier type de conductivité (303) dans des premières régions sur une première face (321) d'une tranche de semi-conducteur (301) ;
d'introduction de dopants d'un deuxième type de conductivité (305) dans des deuxièmes régions sur ladite première face (321) ;
de formage d'une couche protectrice de dioxyde de silicium (307) sur ladite première face (321) ;
de fixation d'une première tranche de manipulation (309) à ladite couche protectrice (307) sur ladite première face (321) en plaçant une surface extrêmement plate de ladite première tranche de manipulation (309) et d'une surface extrêmement plate de ladite couche protectrice (307) ensemble à une température moyenne de 400 °C, afin de former une liaison faible, et en plaçant ensuite les tranches dans un four pendant deux heures à 1100 °C, afin d'amener ladite première tranche de manipulation (309) à se lier directement à ladite couche protectrice (307), ladite première tranche de manipulation (309) étant formée de silicium ;
d'introduction de dopants de premier type de conductivité (303) dans des troisièmes régions sur une deuxième face (323) de ladite tranche de semi-conducteur (301) qui est parallèle à ladite première face (321) ;
d'introduction de dopants de deuxième type de conductivité (305) dans des quatrièmes régions sur ladite deuxième face (323) ;
de réalisation d'une étape de diffusion à haute température à une température supérieure à 600 °C, où ladite étape de diffusion diffuse les dopants de premier type de conductivité (303) et les dopants de deuxième type de conductivité (305) à des profondeurs désirées, à partir à la fois desdites première et deuxième faces (321, 323), jusque dans ladite tranche de semi-conducteur (301) ;
de réalisation d'étapes de fabrication à température moyenne sur ladite deuxième face (323) ;
de fixation, grâce à l'utilisation d'une couche adhésive (337), d'une deuxième tranche de manipulation (319) sur ladite deuxième face (323) ;
d'enlèvement de ladite première tranche de manipulation (309) ; et
de réalisation d'étapes de fabrication à température moyenne sur ladite première face (321).

2. Procédé de la revendication 1, dans lequel à la fois des dopants de type p et de type n sont introduits, en motifs respectifs et pas partout, sur à la fois lesdites première et deuxième faces (321, 323) de ladite tranche de semi-conducteur (301).

3. Procédé de la revendication 1, dans lequel l'étape de diffusion utilise une température soutenue plus élevée que dans n'importe quelle étape ultérieure.

4. Procédé de la revendication 1, dans lequel les étapes d'introduction de dopants (303, 305) dans lesdites première et deuxième régions sur ladite première face (321) utilisent les mêmes motifs que les étapes d'introduction de dopants (303, 305) dans lesdites troisième et quatrième régions sur ladite deuxième face (323), respectivement.

5. Procédé de la revendication 1, dans lequel la connexion entre ladite chaque tranche de manipulation (309, 319) et ladite tranche de semi-conducteur (301) n'est pas affectée par des températures utilisées après l'étape de fixation respective.

6. Procédé de la revendication 1, dans lequel lesdites étapes de fabrication à température moyenne sont réalisées à des températures inférieures à 450 °C.

7. Procédé de la revendication 1, comprenant en outre :
la réalisation d'étapes de fabrication à haute température sur ladite première face (321) de ladite tranche de semi-conducteur (301), avant l'étape d'introduction de dopants de premier type de conductivité (303) dans lesdites premières régions sur ladite première face (321) ;
la réalisation d'étapes de fabrication à haute température sur ladite deuxième face (323) de ladite tranche de semi-conducteur (301), avant l'étape d'introduction de dopants de premier type de conductivité (303) dans lesdites troisièmes régions sur ladite deuxième face (323);
l'enlèvement de ladite deuxième tranche de manipulation (319) de ladite deuxième face (323), après l'étape de réalisation d'étapes de fabrication à température moyenne sur ladite première face (321) ; et
la réalisation d'étapes de traitement à faible température sur ladite tranche de semi-conducteur (301) à des températures inférieures à 240 °C ;
dans lequel les étapes de fabrication à température moyenne sont réalisées à des températures inférieures à 450 °C ; et
dans lequel au moins quelques-unes desdites étapes de fabrication à haute température sont réalisées à des températures supérieures à 600 °C.

8. Procédé de la revendication 7, comprenant en outre le formage de grilles de tranchée (425) sur la face respective avant l'introduction des dopants (303, 305) dans ladite chaque face (321, 323).

9. Procédé de la revendication 7, dans lequel ladite étape de diffusion est réalisée à des températures supérieures à 1000 °C.

10. Procédé de la revendication 1, comprenant en outre, après l'étape de fixation de la première tranche de manipulation (309) à ladite première face (321), et avant l'étape d'introduction de dopants de premier type de conductivité (303) dans lesdites troisièmes régions sur ladite deuxième face (323), une étape :
d'amincissement de ladite tranche de semi-conducteur (301), à partir de ladite deuxième face (323), jusqu'à une épaisseur désirée.
